(19) Europäisches Patentamt
European Patent Office
Office européen des brevets

(11) EP 3 503 163 A1

(12) EUROPEAN PATENT APPLICATION

(43) Date of publication:
**26.06.2019 Bulletin 2019/26**

(51) Int Cl.:
***H01L 21/02*** *(2006.01)*

(21) Application number: **17209740.4**

(22) Date of filing: **21.12.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(71) Applicant: **EpiGan NV**
**3500 Hasselt (BE)**

(72) Inventors:
- **Püsche, Roland**
**4701 Kettenis (BE)**
- **Degroote, Stefan**
**3271 Scherpenheuvel-Zichem (BE)**
- **Derluyn, Joff**
**3051 Sint-Joris-Weert (BE)**

(74) Representative: **IP HILLS NV**
**Hubert Frère-Orbanlaan 329**
**9000 Gent (BE)**

# (54) A METHOD FOR FORMING A SILICON CARBIDE FILM ONTO A SILICON SUBSTRATE

(57) A method for forming silicon carbide (2) onto a silicon substrate (1) by reaction of said silicon substrate (1) and a first precursor (200) comprising indium and a plurality of carbon atoms.

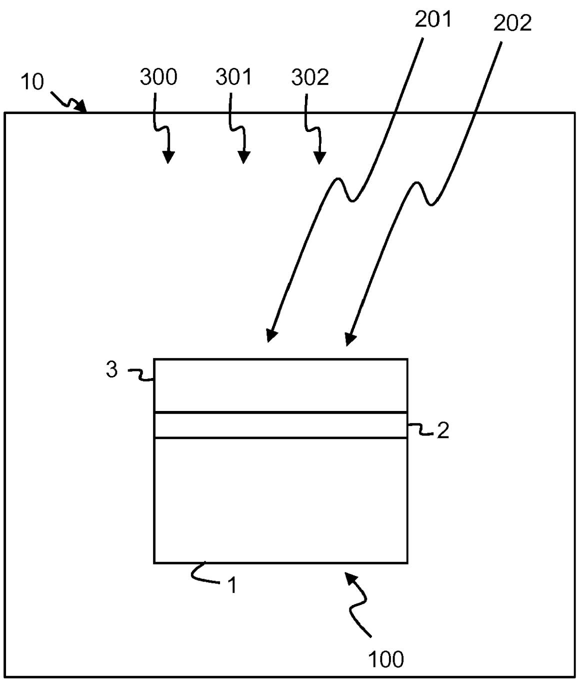


Fig. 1B

EP 3 503 163 A1

## Description

### Field of the Invention

The present invention generally relates to semiconductor process technology and devices. More particularly, the present invention generally relates to an improved method for protecting a silicon substrate during epitaxial deposition of a group III nitride layer on top of the silicon substrate.

### Background of the Invention

Semiconductor devices comprising Gallium Nitride, also referred to as GaN, have the ability to carry large currents and to support high voltages. This makes them increasingly desirable for power semiconductor devices. In the recent years, research efforts focused on developing devices for high power/high frequency applications. In general, the manufactured devices for these types of applications are based on device structures that exhibit high electron mobility and are referred to as heterojunction field effect transistors, also called HFETs, high electron mobility transistors, also called HEMTs, or modulation doped field effect transistors, also called MODFETs. HEMTs are for example useful for analog circuit applications, such as RF/microwave power amplifiers or power switches. Such devices can typically withstand high voltages, e.g. up to 1000 Volts, while operating at high frequencies, e.g. from 100 kHz to 100 GHz.

The semiconductors devices comprising Gallium Nitride are grown on top of substrates comprising silicon, for example silicon substrates also referred to as Si substrates. In order to obtain high-quality GaN layers on top of a Si substrate, a growth method with different steps and optimized processing parameters is used to accommodate for the lattice and the thermal mismatch between GaN and Si. The use of an AlN buffer layer between the silicon substrate and the GaN layer is known from the prior art. However, it is very challenging to grow AlN on top of a Si substrate. Indeed, Al has a low mobility on the surface of the Si substrate and the AlN grows in islands. Lateral growing is then necessary to obtain a layer of AlN on top of a Si substrate. The US patent publication US 2004/0119063 A1 for example describes a device wherein a few monolayers of aluminium are deposited on the silicon substrate to protect the silicon substrate from ammonia and then forming a nucleation layer of AlN and a buffer structure including multiple superlattices of AlGaN semiconductor having different compositions and an intermediate layer of GaN or another Ga-rich nitride semiconductor.

On the other hand, it appears that silicon carbide, also referred to as SiC, is particularly suited for growing a group III nitride layer on top of a silicon substrate, more particularly an AlN layer. Silicon carbide is useful in many high temperature, high power and high frequency semiconductor device applications because of properties such as a wide bandgap, high saturated electron drift velocity, high breakdown electric field, high thermal conductivity and good chemical resistance. The silicon carbide prevents Si diffusion into the layers deposited on top of the silicon carbide, and silicon carbide can also protect the Si substrate from nitridation and can introduce compressive stress in the AlN.

It has been demonstrated that a silicon surface may be carbonized using one or more hydrocarbons. However, this requires heating the silicon substrate up to high temperatures, for example a substrate temperature higher than 1000°C. The US patent US 7666765 B2 of Cheng et al. entitled "Method for forming a group III nitride material on a silicon substrate" for example describes a method for protecting the Si substrate from nitridation and for introducing compressive stress in the AlN. The method is referred to as "pre-dosing" and comprises the use of organometallic compounds. In fact, one or more organometallic compounds comprising Al, for example trimethylaluminium also referred to as TMAl, dimethylaluminium hybride also referred to as DMAl-H, or triethylaluminium also referred to as TEAl are provided in a reaction chamber to provide methyl or ethyl groups for reacting with the Si substrate preferably heated up from 1000°C to 1200°C. Thanks to the use of an ultra-low flow of precursors in US 7666765 B2, the silicon surface is carbonized and consequently passivated by the methyl groups. A monolayer of SiC is formed on top of the Si substrate and an AlN layer can then be grown on top of the resulting SiC/Si stack.

The method described in US 7666765 B2 is very challenging as it requires accurate switching sequences when introducing the organometallic compounds and other gases in the reaction chamber. At a temperature higher than 1000°C, the TMAl is already decomposed in the reaction chamber and the methyl groups and the Al atoms bind to the surface of the silicon substrate. Meanwhile, desorption of the Si substrate also occurs at this temperature. Additionally, Al atoms may diffuse into the Si substrate, which is undesirable.

Alternatively, other methods were developed to carbonize the Si substrate before the growth of a group III nitride material, wherein the methods comprise the use of one or more organometallic compounds comprising Ga, for example trimethylgallium also referred to as TMG or TMGa, dimethylgallium also referred to as DMGa, or triethylgallium also referred to as TEGa.

One of the key issues of the use of Ga-based precursors or of Ga pre-dosing is the issue of melt back etching described in the scientific publication of Krost et al. entitled "GaN-based optoelectronics on silicon substrates" published in Materials Science and Engineering: B, Volume 93, Issues 1-3, pages 77-84 on 30 May 2002. The reaction of Ga on Si indeed results in etching of the Si substrate due to the formation of Ga-rich Ga-Si alloy. The results in the formation

of a rough interface between the SiC and the Si prior to the formation of AlN, which can result in disadvantageous effects on the performance of processed devices.

It is an objective of the present invention to disclose a device that overcomes the above identified shortcomings of existing solutions. More particularly, it is an objective to disclose a method for protecting a silicon substrate during epitaxial deposition of a group III nitride layer on top of the silicon substrate.

## Summary of the Invention

According to a first aspect of the present invention, the above defined objectives are realized by a method for forming silicon carbide onto a silicon substrate by reaction of the silicon substrate and a first precursor comprising indium and a plurality of carbon atoms.

The present invention provides an improved method for the in-situ protection of the surface of a silicon substrate during the epitaxial deposition of a wide bandgap material such as for example a group III nitride layer on top of the silicon substrate. In other words, the method according to the present invention is an improved method for growing silicon carbide or SiC in-situ on top of a silicon substrate. The first precursor of the present invention used for the in-situ formation of SiC onto the silicon substrate comprises Indium, also referred to as In, and further comprises a plurality of carbon atoms. For example, the first precursor according to the present invention comprises trimethylindium, also referred to as TMIn. The Si substrate is loaded into a reaction chamber suitable for epitaxial growth, for example a reaction chamber in a Metal-Organic Chemical Vapour Deposition reactor or MOCVD reactor, or a Molecular Beam Epitaxy reactor or MBE reactor, or an Atomic Layer Deposition reactor or ALD reactor, Chemical Beam Epitaxy reactor, or a Metalorganic Vapour Phase Epitaxy reactor or MOVPE reactor, etc.. The Si substrate is heated up in-situ at a temperature comprised between 500°C and 1400°C, preferably comprised between 800°C and 1400°C, more preferably comprised between 900°C and 1300°C, and even more preferably comprised between 1000°C and 1200°C. The decomposition temperature of the first precursor comprising indium and a plurality of carbon atoms is comprised between 700°C and 1200°C. The publication of R.E. Honig entitled "Vapor Pressure Data for the More Common Elements" published in 1957 in the RCA Review 18, pages 195-204, lists the vapor pressures In, Al and Ga for different temperatures. At 1000°C for example, Ga has a vapor pressure close to $5.10^{-6}$ atm, while Al has a vapor pressure close to $2.10^{-7}$ atm. On the contrary, In has a vapor pressure close to $5.10^{-5}$ atm at 1000°C. Indium therefore has a higher vapor pressure than Al and Ga: the indium evaporates from the silicon substrate at this temperature when the first precursor is provided in the reaction chamber onto the silicon substrate. The pressure in the reactor is preferably from about 20 mbar to 100 mbar. Additionally, the publication of S.K. Ghandhi entitled "The Theory and Practice of Microelectronics", published by John Wiley in 1968 presents the size of impurities atoms relative to silicon. When the size of an atom of silicon is 1.0, the size of an atom of aluminium is 1.07 and the size of an atom of gallium is 1.07. However, the size of an atom of indium is 1.22 when the size of an atom of silicon is 1.0. Indium therefore has a lower solubility than Al and Ga in the silicon substrate. The indium atoms therefore migrate less in the silicon substrate than Al or Ga atoms would do at this temperature. The surface of the silicon substrate in the present invention is therefore carbonized with the carbon atoms of the first precursor, thereby resulting in the formation of silicon carbide on top of the silicon substrate.

The first precursor is introduced in its gaseous form or in a gaseous composition. The first precursor can be diluted in $N_2$ or in any noble gas such as He or Ar, and preferably in $H_2$ gas. The gaseous composition can further comprise traces of nitrogen which can react with the silicon substrate, thereby forming SiN, resulting in a silicon substrate partially covered with SiC and partially covered with SiN, with mutually adjacent regions of SiC and SiN. Also, it is possible that SiN is already present as a contaminant on parts of the silicon substrate before the pre-dosing step. In that case, the pre-dosing step deposits SiC in between the regions of SiN and the silicon substrate is covered in adjacent regions of SiC and SiN. It is understood by the skilled person that the expression SiN is not limited to the compound that is strictly defined by the stochiometric ration of the chemical formula for silicon nitride, i.e. $Si_3N_4$. In a layer of SiN, a deviation from the stochiometric ratio may be present.

The silicon carbide may be a layer comprising SiC over the whole surface of the silicon substrate. Alternatively, the silicon carbide may be a layer comprising one or more regions of SiC and one or more regions of silicon nitride, also referred to as SiN. The SiC regions may have a thickness of for example maximum 3 nm. Alternatively, the SiC regions may have a thickness of a few nanometers, preferably smaller than 5nm. The SiC regions may comprise one SiC monolayer, or a stack of SiC monolayers on top of each other. Alternatively, the silicon carbide may be for example monolayers of SiC, more particularly atomic monolayers of SiC. The silicon carbide in this case comprises a stack of several SiC monolayers, for example 2 or 3 monolayers, on top of each other, over the whole surface of the silicon substrate. This number of monolayers can be uniform over the whole surface of the silicon substrate or can vary over the surface of the silicon substrate. The number of monolayers may depend on the period during which the first precursor is provided in the reaction chamber.

SiC shows a crystalline structure. SiC has a stoichiometric composition and the crystalline structure of the SiC improves the quality of group III nitride layers later possibly grown on top of the resulting SiC/Si stack.

According to an optional aspect of the invention, the method comprising the steps of:

- loading the silicon substrate in a reaction chamber; and
- subjecting the silicon substrate in the reaction chamber to a reaction cycle, the reaction cycle comprising supplying to said reaction chamber the first precursor at a temperature exceeding a temperature threshold and at a partial pressure exceeding a partial pressure threshold, thereby forming the silicon carbide onto the silicon substrate.

In the context of the present invention, providing the first precursor comprising indium and a plurality of carbon atoms can be referred to as the "pre-dosing step". The method comprises providing at least 10 μmol of the first precursor, in a flow of less than 50 $\mu mol.min^{-1}$, preferably less than 10 $\mu mol.min^{-1}$, or less than 2 $\mu mol.min^{-1}$, but not null.

According to an optional aspect of the invention, the first precursor comprises indium and a plurality of organic molecules comprising carbon atoms.

According to an optional aspect of the invention, the first precursor comprises indium and a plurality of methyl groups.

At a high temperature, both the precursor decomposition rate and the desorption rate are enhanced. The first precursor is decomposed to methyl groups and indium atoms at high temperature, more precisely to a mono-metal indium and two metal groups in gas phase, as follows:

$$In(CH_3)_3 + H_2 \leftrightarrow InCH_3 + 2CH_4 \quad (1)$$

Then, methyl groups and indium atoms are bound to the surface of the silicon substrate. Meanwhile, desorption of the silicon substrate also occurs. By providing a low flow of the first precursor, equilibrium between decomposition of the first precursor and desorption is achieved and thus no indium atoms are accumulated on the surface of the silicon substrate. Indeed, the bond between methyl groups and silicon atoms is stronger. The silicon substrate is therefore carbonized and passivated by methyl groups.

According to an optional aspect of the invention, the temperature threshold is comprised between 750°C and 1000°C.

According to an optional aspect of the invention, the partial pressure threshold is larger than $1.10^{-6}$ mBar.

The partial pressure of the TMIn is equal : $\frac{flow\ TMIn}{total\ flow}$. pressure in the reactor. The total flow comprises a mixture of hydrogen and nitrogen and the total flow is for example about 1 mole/min. The flow of TMIn is for example between 2 and 10 μmole/min. The pressure in the reactor is for example set to 40 mBar, preferably being comprised between 20 to 100mBar. The partial pressure of TMIn is then for example minimum at $40.10^{-6}$ mBar, and the partial pressure of TMIn is preferably larger than $1.10^{-6}$ mBar.

According to an optional aspect of the invention, subjecting the silicon substrate in the reaction chamber to a reaction cycle further comprises supplying to the reaction chamber a purge gas, or a reducing gas, or combinations thereof.

According to an optional aspect of the invention, the reaction chamber is suitable for epitaxial growth in a Metal-Organic Chemical Vapour Deposition reactor, or a Molecular Beam Epitaxy reactor, or an Atomic Layer Deposition reactor, or a Chemical Beam Epitaxy reactor, or a Metalorganic Vapour Phase Epitaxy reactor.

According to an optional aspect of the invention, the silicon carbide comprises a silicon carbide film.

According to an optional aspect of the invention, when a thickness of the silicon carbide film exceeds a predetermined thickness threshold, the method further comprises the step of supplying ammonia and a second precursor comprising aluminium to the reaction chamber, thereby growing an aluminium nitride layer on top of the silicon carbide film.

A SiC/Si template obtained by carrying out the method according to the present invention appears to be very suitable for the further growth of AIN with very high epitaxial quality and low stress. The second precursor comprises ammonia and all compounds which contain a metal from group three in the periodic system of the elements with as ligand an alkyl, so a group containing carbon and hydrogen. At least one of the ligands should be methyl, ethyl or propyl in order to be able to donate carbon to the silicon substrate.

According to an optional aspect of the invention, the predetermined thickness threshold is comprised between a thickness of a monolayer of silicon carbide and 3 nm of silicon carbide.

Alternatively, the predetermined thickness threshold is comprised between a thickness of a monolayer of silicon carbide and a few nanometers of silicon carbide, for example between a thickness of a monolayer of silicon carbide and less than 5nm of silicon carbide.

According to an optional aspect of the invention, supplying the ammonia and the second precursor comprising aluminium comprises supplying first the ammonia and then supplying the second precursor.

This way, the first reactor is purged from the first precursor before the second precursor is provided into the reaction chamber.

According to an optional aspect of the invention, supplying the ammonia and the second precursor comprising aluminium comprises supplying first the second precursor and then supplying the ammonia.

This way, the growth of SiN on top of the silicon substrate is minimized. Providing the second precursor allows to grow the aluminium nitride layer on top of the silicon substrate, more particularly on top of the silicon carbide.

According to an optional aspect of the invention, the method further comprises suspending the supply of the first precursor to the reaction chamber prior to supplying the ammonia and the second precursor to the reaction chamber.

This way, no reaction can take place between the first precursor and the ammonia and/or between the first precursor and the second precursor in the reaction chamber.

According to an optional aspect of the invention, the method comprises keeping supplying to the reaction chamber the first precursor at the temperature exceeding a temperature threshold and at the partial pressure exceeding a partial pressure threshold when supplying the ammonia and the second precursor to the reaction chamber.

This way, the surface of the silicon substrate is being carbonized and thereby passivated by growing silicon carbide and/or silicon nitride.

According to an optional aspect of the invention, the purge gas is nitrogen and wherein the reducing gas is hydrogen.

This way, the surface of the silicon substrate is cleaned before the growth of the silicon carbide. Native oxide is removed in-situ by the reducing gas, thereby resulting in a pristine surface of the silicon substrate ready for the growth of silicon carbide.

According to an optional aspect of the invention, the method further comprises supplying silane to the reaction chamber.

This way, the growth of silicon carbide on top of the silicon substrate is enhanced. Indeed, the decomposition temperature of silane is such that silane provides silicon atoms in the reaction chamber for example when the first precursor is provided in the reaction chamber. Additionally, silane could be used prior to the growth of silicon carbide to deposit a film of silicon oxide on top of the silicon substrate. The resulting $SiO_2$/Si stack would then be subjected to the flow of the first precursor to grow the silicon carbide.

According to a second aspect of the invention, there is provided a semiconductor structure comprising:

- a silicon substrate;
- silicon carbide formed onto the silicon substrate by reaction of the silicon substrate and a first precursor comprising indium and a plurality of carbon atoms.

According to an optional aspect of the invention, the silicon carbide is formed when supplying onto the silicon substrate the first precursor at a temperature exceeding a temperature threshold and a partial pressure exceeding a partial pressure threshold; and wherein the silicon carbide acts as a diffusion barrier for Group III elements into the silicon substrate.

The present invention provides a semiconductor structure comprising a surface of a silicon substrate which is protected in-situ during the epitaxial deposition of a wide bandgap material such as for example a group III nitride layer on top of the silicon substrate. In other words, the semiconductor structure according to the present invention is comprises silicon carbide or SiC in-situ epitaxially grown on top of a silicon substrate. The first precursor of the present invention used for the in-situ formation of SiC onto the silicon substrate comprises Indium, also referred to as In, and further comprises a plurality of carbon atoms. The Si substrate is loaded into a reaction chamber suitable for epitaxial growth, for example a reaction chamber in a Metal-Organic Chemical Vapour Deposition reactor or MOCVD reactor, or a Molecular Beam Epitaxy reactor or MBE reactor, or an Atomic Layer Deposition reactor or ALD reactor, Chemical Beam Epitaxy reactor, or a Metalorganic Vapour Phase Epitaxy reactor or MOVPE reactor, etc.. The Si substrate is heated up in-situ at a temperature comprised between 500°C and 1400°C, preferably comprised between 800°C and 1400°C, more preferably comprised between 900°C and 1300°C, and even more preferably comprised between 1000°C and 1200°C. The decomposition temperature of the first precursor comprising indium and a plurality of carbon atoms is comprised between 700°C and 1200°C. The publication of R.E. Honig entitled "Vapor Pressure Data for the More Common Elements" published in 1957 in the RCA Review 18, pages 195-204, lists the vapor pressures In, Al and Ga for different temperatures. At 1000°C for example, Ga has a vapor pressure close to $5.10^{-5}$ atm, while Al has a vapor pressure close to $2.10^{-7}$ atm. On the contrary, In has a vapor pressure close to $5.10^{-5}$ atm at 1000°C. Indium therefore has a higher vapor pressure than Al and Ga: the indium evaporates from the silicon substrate at this temperature when the first precursor is provided in the reaction chamber onto the silicon substrate. The pressure in the reactor is preferably from about 20 mbar to 100 mbar. Additionally, the publication of S.K.Ghandhi entitled "The Theory and Practice of Microelectronics", published by

John Wiley in 1968 presents the size of impurities atoms relative to silicon. When the size of an atom of silicon is 1.0, the size of an atom of aluminium is 1.07 and the size of an atom of gallium is 1.07. However, the size of an atom of indium is 1.22 when the size of an atom of silicon is 1.0. Indium therefore has a lower solubility than Al and Ga in the silicon substrate. The indium atoms therefore migrate less in the silicon substrate than Al or Ga atoms would do at this temperature. The surface of the silicon substrate in the present invention is therefore carbonized with the carbon atoms of the first precursor, thereby resulting in the formation of silicon carbide on top of the silicon substrate.

The silicon carbide formed on top of the silicon substrate acts as a diffusion barrier for Group III elements into the silicon substrate. For example, the silicon carbide acts as a diffusion barrier for aluminium atoms and/or gallium atoms of layers formed onto the silicon carbide into the silicon substrate. In other words, when ammonia and a second precursor comprising aluminium are supplied to the reaction chamber to grow an aluminium nitride layer on top of the silicon carbide on top of the silicon substrate, the silicon carbide acts as a diffusion barrier for the aluminium atoms of this aluminium nitride layer. In other words, when for example an aluminium nitride layer is present on top of the silicon carbide on top of the silicon substrate, the silicon carbide acts as a diffusion barrier for the aluminium atoms of this aluminium nitride layer. Silicon carbide further acts as a diffusion barrier for Group III elements of additional layers formed onto this aluminium nitride layer into the silicon substrate. For example, the silicon carbide further acts as a diffusion barrier for aluminium atoms and/or gallium atoms of additional layers formed onto this aluminium nitride layer into the silicon substrate.

According to a third aspect of the invention, there is provided the use of a first precursor comprising indium and a plurality of carbon atoms for forming silicon carbide onto a silicon substrate in a reaction chamber, wherein forming the silicon carbide comprises:

- loading the silicon substrate in a reaction chamber; and
- subjecting the silicon substrate in the reaction chamber to a reaction cycle comprising supplying to the reaction chamber the first precursor at a temperature exceeding a temperature threshold and at a partial pressure exceeding a partial pressure threshold.

## Brief Description of the Drawings

Fig. 1A and 1B schematically illustrate an embodiment of a semiconductor structure according to the present invention.

Fig. 2 schematically illustrates an embodiment of the steps of a method according to the present invention.

Fig. 3 schematically illustrates solubility of Al, Ga and In atoms in silicon in function of the temperature of the silicon.

## Detailed Description of Embodiment(s)

According to an embodiment shown in Fig. 1A, a semiconductor structure 100 according to the present invention is loaded in a reaction chamber 10. The semiconductor structure 100 comprises a silicon substrate 1 and a silicon carbide 2 formed onto the silicon substrate 1 by reaction of the silicon substrate 1 and a first precursor 200 comprising indium and a plurality of carbon atoms. The silicon carbide 2 is formed when supplying onto the silicon substrate 1 the first precursor 200 at a temperature exceeding a temperature threshold and at a partial pressure exceeding a partial pressure threshold. The silicon carbide acts as a diffusion barrier for Group III elements into the silicon substrate 1. The first precursor 200 comprises indium and a plurality of organic molecules comprising carbon atoms. The first precursor 200 comprises indium and a plurality of methyl groups. The temperature threshold is comprised between 750°C and 1000°C and the partial pressure threshold is larger than $1.10^{-6}$ mBar, preferably at least $40.10^{-6}$ mBar. According to an embodiment shown in Fig. 1B, the semiconductor structure 100 of Fig. 1A is subjected to a purge gas 300 or a reducing gas 301 or combinations thereof. The purge gas 300 is nitrogen and the reducing gas 301 is hydrogen. The reaction chamber 10 is for example a reaction chamber for epitaxial growth in a MOCVD reaction, a MBE reactor, an ALD reactor or a Chemical Beam Epitaxy reactor. The silicon carbide 2 is a silicon carbide film 2. When the thickness of the silicon carbide 1 exceeds a predetermined thickness threshold, ammonia 201 and a second precursor 202 comprising aluminium are supplied to the reaction chamber 10. According to an alternative embodiment, silane 302 may be supplied to the reaction chamber 10.

According to an embodiment of the steps of the method according to the present invention shown in Fig. 2, silicon carbide 2 is formed on to a silicon substrate 1 by reaction of the silicon substrate 1 and a first precursor 200 comprising indium and a plurality of carbon atoms. In a first step 21, the silicon substrate 2 is loaded in a reaction chamber 10, which can be a reaction chamber for epitaxial growth in a MOCVD reaction, a MBE reactor, an ALD reactor or a

Chemical Beam Epitaxy reactor. In a second step 22, the silicon substrate 2 is then subjected in the reaction chamber 10 to a reaction cycle, the reaction cycle comprising supplying the first precursor 200 to the reaction chamber 10 at a temperature exceeding a temperature threshold and at a partial pressure exceeding a partial pressure threshold, thereby forming the silicon carbide 2 onto the silicon substrate 1. The first precursor 200 comprises indium and a plurality of organic molecules comprising carbon atoms. The first precursor 200 comprises indium and a plurality of methyl groups. The temperature threshold is comprised between 750°C and 1000°C and the partial pressure threshold is larger than $1.10^{-6}$ mBar, preferably at least $40.10^{-6}$ mBar.. The reaction cycle further comprises supplying a purge gas 300 to the reaction chamber 10 or a reducing gas 301 or combinations thereof. The purge gas 300 is nitrogen and the reducing gas 301 is hydrogen. In an optional third step 23, when the thickness of the silicon carbide 1 exceeds a predetermined thickness threshold, ammonia 201 and a second precursor 202 comprising aluminium are supplied to the reaction chamber 10. The second precursor 202 is supplied first and then the ammonia 201 is supplied. According to an alternative embodiment, the ammonia 201 is supplied first and the second precursor 202 is supplied after. The method comprises keeping the first precursor 200 supplied to the reaction chamber 10 at a temperature exceeding a temperature threshold and at a partial pressure exceeding a partial pressure threshold when suppling the ammonia 201 and the second precursor 202 to the reaction chamber 10. According to an alternative embodiment, the method comprises suspending the first precursor 200 supplied to the reaction chamber 10 at a temperature exceeding a temperature threshold and at a partial pressure exceeding a partial pressure threshold when suppling the ammonia 201 and the second precursor 202 to the reaction chamber 10. According to a further alternative embodiment, silane 302 may be supplied to the reaction chamber 10 in step 2 and/or step 3 of the method.

According to an embodiment shown in Fig. 3, the solubility 24 of aluminium, gallium and indium atoms in silicon is plotted as a function of temperature 25. The points 26 on Fig. 3 are related to the solubility 24 in atoms.$cm^{-3}$ of aluminium atoms in a silicon substrate as a function of the temperature 25 of the silicon substrate in degrees Celsius. The points 27 on Fig. 3 are related to the solubility 24 in atoms.$cm^{-3}$ of gallium atoms in a silicon substrate as a function of the temperature 25 of the silicon substrate in degrees Celsius. The points 28 on Fig. 3 are related to the solubility 24 in atoms.$cm^{-3}$ of indium atoms in a silicon substrate as a function of the temperature 25 of the silicon substrate in degrees Celsius. It can clearly be seen that aluminium and gallium atoms demonstrate a much higher solubility in silicon that indium atoms. For example, at 1000°C, gallium atoms demonstrate a solubility 27 of $1,6.10^{19}$ atoms.$cm^{-3}$, while indium atoms demonstrate a solubility 28 of $3.10^{19}$ atoms.$cm^{-3}$. For example, at 1200°C, gallium atoms demonstrate a solubility 26 of $2.10^{19}$ atoms.$cm^{-3}$, while indium atoms demonstrate a solubility 28 of $2,5.10^{19}$ atoms.$cm^{-3}$. Growing silicon carbide 2 on top of a silicon substrate therefore prevents the diffusion of Group III elements such as aluminium and/or gallium atoms into the silicon substrate at high temperatures of the silicon substrate. In other words, the silicon carbide 2 deposited on top of the silicon substrate 1 acts as a diffusion barrier from Group III elements into the silicon substrate 1 at high temperatures, for example at temperature higher than 1000°C.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the meaning and range of equivalency of the claims are therefore intended to be embraced therein. In other words, it is contemplated to cover any and all modifications, variations or equivalents that fall within the scope of the basic underlying principles and whose essential attributes are claimed in this patent application. It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. Similarly, the terms "top", "bottom", "over", "under", and the like are introduced for descriptive purposes and not necessarily to denote relative positions. It is to be understood that the terms so used are interchangeable under appropriate circumstances and embodiments of the invention are capable of operating according to the present invention in other sequences, or in orientations different from the one(s) described or illustrated above.

## Claims

1. A method for forming silicon carbide (2) onto a silicon substrate (1) by reaction of said silicon substrate (1) and a first precursor (200) comprising indium and a plurality of carbon atoms.

**2.** A method according to claim 1, wherein said method further comprises the steps of:

- loading said silicon substrate (2) in a reaction chamber (10); and
- subjecting said silicon substrate (2) in said reaction chamber (10) to a reaction cycle, said reaction cycle comprising supplying to said reaction chamber (10) said first precursor (200) at a temperature exceeding a temperature threshold and at a partial pressure exceeding a partial pressure threshold, thereby forming said silicon carbide (2) onto said silicon substrate (1).

**3.** A method according to any of the preceding claims, wherein said first precursor (200) comprises indium and a plurality of organic molecules comprising carbon atoms.

**4.** A method according to any of the preceding claims, wherein said first precursor (200) comprises indium and a plurality of methyl groups.

**5.** A method according to any of the preceding claims, wherein said subjecting said silicon substrate (1) in said reaction chamber (10) to a reaction cycle further comprises supplying to said reaction chamber (10) a purge gas (300), or a reducing gas (301), or combinations thereof.

**6.** A method according to any of the preceding claims, wherein said reaction chamber (10) is suitable for epitaxial growth in a Metal-Organic Chemical Vapour Deposition reactor, or a Molecular Beam Epitaxy reactor, or an Atomic Layer Deposition reactor, or a Chemical Beam Epitaxy reactor, or a Metalorganic Vapour Phase Epitaxy reactor reactor.

**7.** A method according to any of the preceding claims, wherein said silicon carbide (2) comprises a silicon carbide film (2).

**8.** A method according to claim 7, wherein, when a thickness of said silicon carbide film (2) exceeds a predetermined thickness threshold, said method further comprises the step of supplying ammonia (201) and a second precursor (202) comprising aluminium to said reaction chamber (10), thereby growing an aluminium nitride layer (3) on top of said silicon carbide film (2).

**9.** A method according to claim 8, wherein said predetermined thickness threshold is comprised between a thickness of a monolayer of silicon carbide and 3 nm of silicon carbide.

**10.** A method according to claim 8, wherein said method further comprises suspending said supply of said first precursor (200) to said reaction chamber (10) prior to said supplying said ammonia (201) and said second precursor (202) to said reaction chamber (10).

**11.** A method according to claim 8, wherein said method comprises keeping supplying to said reaction chamber (10) said first precursor (200) at said temperature exceeding a temperature threshold and at said partial pressure exceeding a partial pressure threshold when supplying said ammonia (201) and said second precursor (202) to said reaction chamber (10).

**12.** A method according to any of the preceding claims, wherein said method further comprises supplying silane (302) to said reaction chamber (10).

**13.** A semiconductor structure (100) comprising:

- a silicon substrate (1);
- silicon carbide (2) formed onto said silicon substrate (1) by reaction of said silicon substrate (1) and a first precursor (200) comprising indium and a plurality of carbon atoms.

**14.** A semiconductor structure (100) according to claim 13, wherein said silicon carbide (2) is formed when supplying onto said silicon substrate (1) said first precursor (200) at a temperature exceeding a temperature threshold and at a partial pressure exceeding a partial pressure threshold; and wherein said silicon carbide (2) acts as a diffusion barrier for Group III elements into said silicon substrate (1).

**15.** Use of a first precursor (200) comprising indium and a plurality of carbon atoms for forming silicon carbide (2) onto a silicon substrate (1) in a reaction chamber (10), wherein said forming said silicon carbide (2) comprises:

- loading said silicon substrate (1) in a reaction chamber (10); and
- subjecting said silicon substrate (1) in said reaction chamber (10) to a reaction cycle comprising supplying to said reaction chamber (10) said first precursor (200) at a temperature exceeding a temperature threshold and at a partial pressure exceeding a partial pressure threshold.

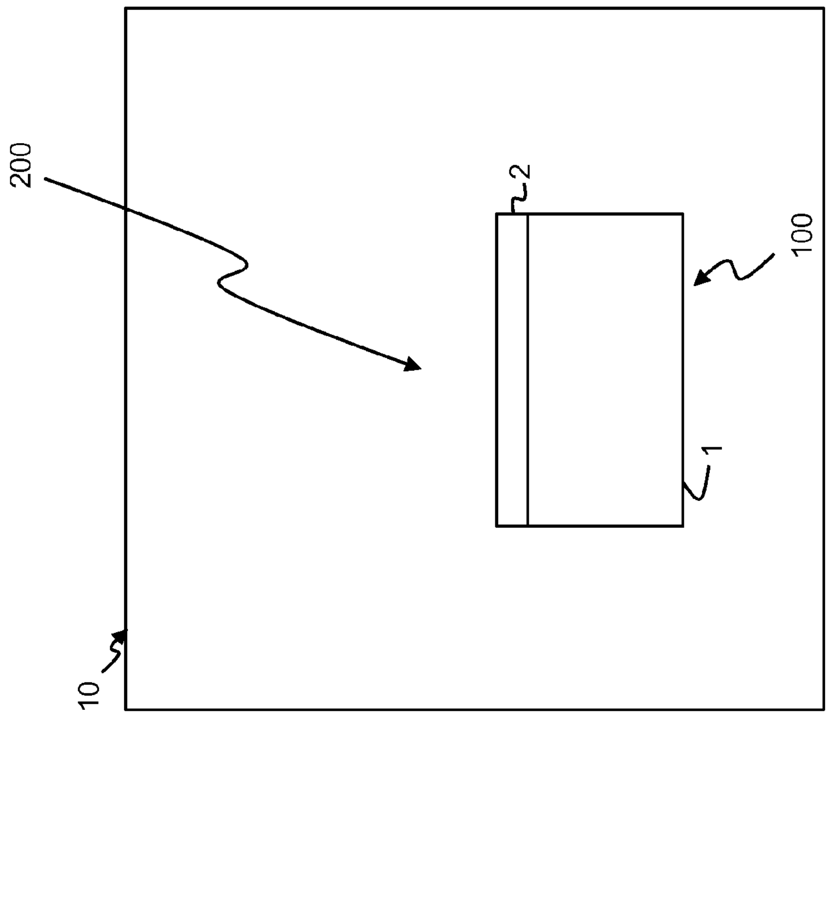


Fig. 1A

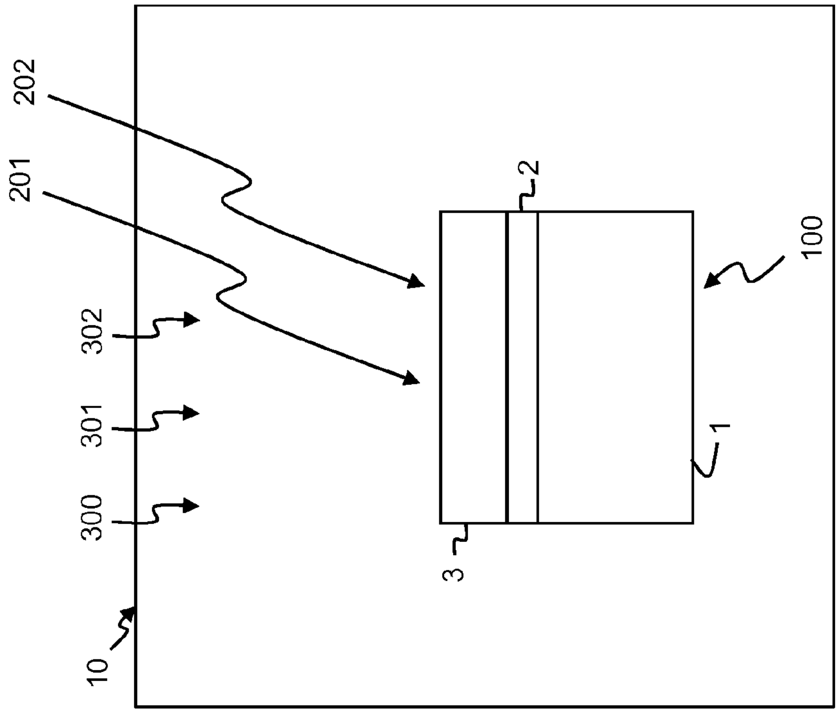


Fig. 1B

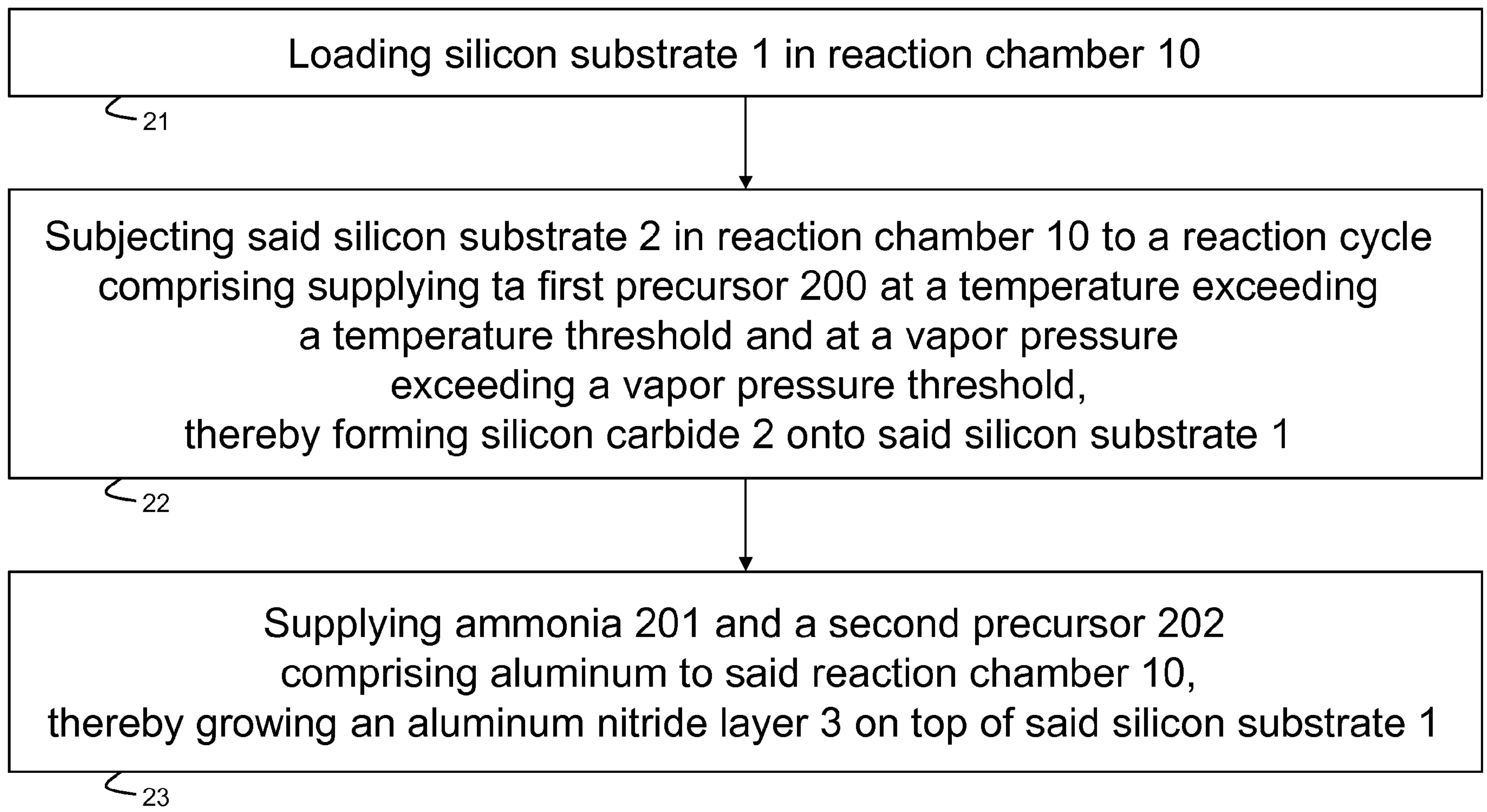
Loading silicon substrate 1 in reaction chamber 10
21
Subjecting said silicon substrate 2 in reaction chamber 10 to a reaction cycle comprising supplying ta first precursor 200 at a temperature exceeding a temperature threshold and at a vapor pressure exceeding a vapor pressure threshold, thereby forming silicon carbide 2 onto said silicon substrate 1
22
Supplying ammonia 201 and a second precursor 202 comprising aluminum to said reaction chamber 10, thereby growing an aluminum nitride layer 3 on top of said silicon substrate 1
23

Fig. 2

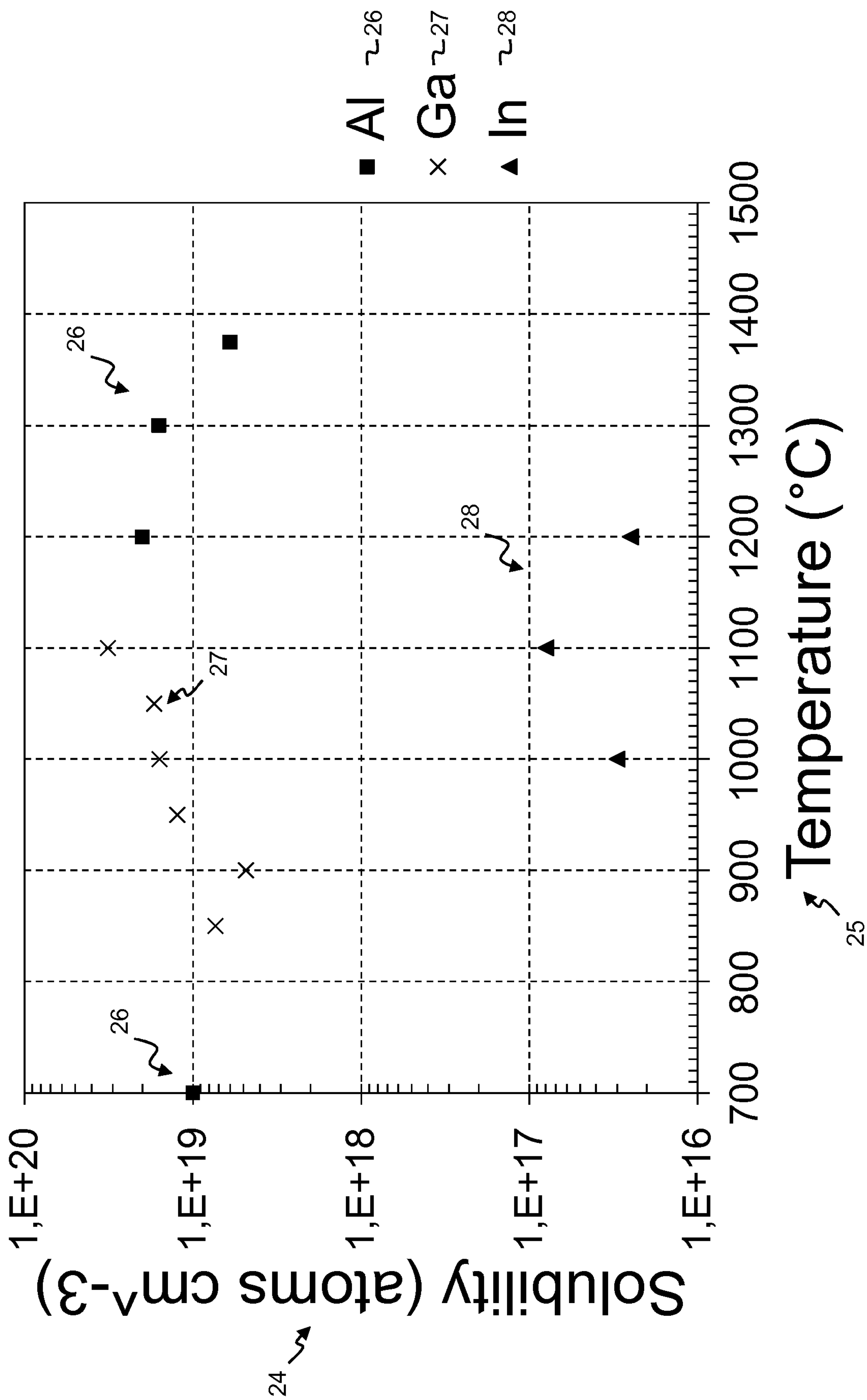

Solubility (atoms cm^-3)
24
1,E+20
1,E+19
1,E+18
1,E+17
1,E+16
700
800
900
1000
1100
1200
1300
1400
1500
Temperature (°C)
25
26
27
28
Al 26
Ga 27
In 28


Fig. 3

Europäisches Patentamt
European Patent Office
Office européen des brevets

# EUROPEAN SEARCH REPORT

Application Number
EP 17 20 9740

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/238315 A1 (CHENG KAI [BE] ET AL) 11 October 2007 (2007-10-11)<br>* paragraph [0009] *<br>----- | 13,14 | INV.<br>H01L21/02 |
| X | TAKEUCHI T ET AL: "Growth of single crystalline GaN film on Si substrate using 3C-SiC as an intermediate layer",<br>JOURNAL OF CRYSTAL GROWTH, ELSEVIER, AMSTERDAM, NL,<br>vol. 115, no. 1-4,<br>2 December 1991 (1991-12-02), pages 634-638, XP024450746,<br>ISSN: 0022-0248, DOI: 10.1016/0022-0248(91)90817-O<br>[retrieved on 1991-12-02]<br>* abstract *<br>----- | 13,14 | |
| A | US 2006/286782 A1 (GASKA REMIGIJUS [US] ET AL) 21 December 2006 (2006-12-21)<br>* paragraph [0029] - paragraph [0031] *<br>----- | 1-15 | |
| A | BUCHAN N I ET AL: "Mass spectrometric studies of trimethylindium pyrolysis",<br>JOURNAL OF CRYSTAL GROWTH, ELSEVIER, AMSTERDAM, NL,<br>vol. 92, no. 3-4,<br>2 October 1988 (1988-10-02), pages 591-604, XP024438048,<br>ISSN: 0022-0248, DOI: 10.1016/0022-0248(88)90044-9<br>[retrieved on 1988-10-02]<br>* the whole document *<br>----- | 1-15 | TECHNICAL FIELDS SEARCHED (IPC)<br>H01L |

The present search report has been drawn up for all claims

1

| Place of search | Date of completion of the search | Examiner |
|---|---|---|
| Munich | 24 May 2018 | Bruckmayer, Manfred |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# ANNEX TO THE EUROPEAN SEARCH REPORT ON EUROPEAN PATENT APPLICATION NO. EP 17 20 9740

This annex lists the patent family members relating to the patent documents cited in the above-mentioned European search report. The members are as contained in the European Patent Office EDP file on
The European Patent Office is in no way liable for these particulars which are merely given for the purpose of information.

24-05-2018

| Patent document cited in search report | Publication date | Patent family member(s) | Publication date |
|---|---|---|---|
| US 2007238315 A1 | 11-10-2007 | EP 1842940 A1 | 10-10-2007 |
| | | EP 1842941 A1 | 10-10-2007 |
| | | JP 5334377 B2 | 06-11-2013 |
| | | JP 2007281478 A | 25-10-2007 |
| | | US 2007238315 A1 | 11-10-2007 |
| | | US 2009294777 A1 | 03-12-2009 |
| US 2006286782 A1 | 21-12-2006 | EP 1911072 A2 | 16-04-2008 |
| | | US 2006286782 A1 | 21-12-2006 |
| | | WO 2007002028 A2 | 04-01-2007 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20040119063 A1
- US 7666765 B2, Cheng


### Non-patent literature cited in the description


- **KROST et al.** GaN-based optoelectronics on silicon substrates. *Materials Science and Engineering: B,* 30 May 2002, vol. 93 (1-3), 77-84
- **R.E. HONIG.** Vapor Pressure Data for the More Common Elements. *RCA Review,* 1957, vol. 18, 195-204
- **S.K. GHANDHI.** The Theory and Practice of Microelectronics. John Wiley, 1968
- **S.K.GHANDHI.** The Theory and Practice of Microelectronics. John Wiley, 1968